# EUROPÄISCHE PATENTSCHRIFT

(11) **EP 2 853 981 B1**
(45) Veröffentlichungstag und Bekanntmachung des Hinweises auf die Patenterteilung: **18.11.2015**
(21) Anmeldenummer: 13186297.1
(22) Anmeldetag: 27.09.2013
(51) Int. Cl.: H05K 5/04, G06F 1/18

(54) **Gehäuse für elektrische Geräte**
Housing for electric devices
Boîtier pour appareils électriques

(43) Veröffentlichungstag der Anmeldung: 01.04.2015
(73) Patentinhaber: Pentair Technical Solutions GmbH, 75334 Straubenhardt (DE)
(72) Erfinder: Joist, Michael, 76571 Gaggenau (DE); Curatolo, Stefan, 76461 Muggensturm (DE)
(74) Vertreter: Durm & Partner

(56) Entgegenhaltungen:
- DE-U1- 29 721 480
- US-A- 6 114 622

## Beschreibung

Die Erfindung betrifft ein Gehäuse für elektrische Geräte, welches aus wenigstens vier Gehäuseteilen aus gebogenem Blech zusammengesetzt ist.

Für einzelne elektronische Geräte werden gerne Gehäuse verwendet, die im Wesentlichen nur aus, gebogenen Blechzuschnitten bestehen. Das hat den Vorteil, dass keine größenabhängigen Formteile, wie zum Beispiel Rahmen oder Seitenteile aus Druckguss, hergestellt und vorgehalten werden müssen. Die Abmessungen des Gehäuses in allen drei Richtungen, also Breite, Höhe und Tiefe, lassen sich dadurch variabel festlegen, so dass flexibel auf veränderte Anforderungen reagiert werden kann. Außerdem lassen sich Blechteile aus Stahl oder Aluminium durch NC- oder Laserbearbeitung kostengünstig und flexibel herstellen. Kundenspezifische Sonderwünsche wie zum Beispiel spezielle Löcher oder Ausnehmungen in Front- oder Rückwand oder zusätzliche Lüftungsschlitze im Deckel können bei Bedarf zusammen mit der Standardbearbeitung erfüllt werden. Gehäuse, die lediglich aus einigen wenigen Blechteilen zusammengesetzt sind, sind somit besonders für kleinere Losgrößen bis hinunter zur Einzelanfertigung besonders geeignet.

Zum Einbau der Ausbauteile wie Hauptplatine, elektronische Steckbaugruppen oder Stromversorgungen, müssen die Gehäuse immer mehrteilig ausgeführt sein. Die eingebauten Teile müssen auch nach der Montage zugänglich bleiben, um zum Beispiel Tests durchzuführen oder defekte Teile auszutauschen. Trotzdem muss das geschlossene Gehäuse möglichst gut abgedichtet sein, insbesondere dann, wenn eine hohe Abschirmung gegen elektromagnetische Wellen (EMV) gefordert ist.

Bekannt sind Gehäuse, die aus zwei U-förmigen gebogenen Blechteilen bestehen, die gegeneinander gesetzt werden. Es sind auch dreiteilige Gehäuse bekannt, die aus einem mehrfach abgekanteten Basisteil, einem ebenen Deckel und einer ebenen abnehmbaren Frontplatte bestehen. Bekannte Gehäuse, die aus vier Teilen bestehen, umfassen zum Beispiel U-förmiges Bodenteil, Frontplatte, Rückseite und U-förmig gebogene Deckelhaube.

Um die einzelnen Teile zusammenzusetzen, bedarf es spezieller Verbindungsmittel. In Betracht kommen zum Beispiel angeformte Haken, Laschen oder Zungen, die in korrespondierende Ausnehmungen des benachbarten Blechteils eingreifen. Front- und/oder Rückseite sowie Deckel werden oft auch aufgeschraubt, um sie bei Bedarf wieder abnehmen zu können. Schrauben ist allerdings zeitaufwendig und bedarf eines Werkzeugs. Gehäuse, deren Einzelteile nur durch Klemm- oder Rastverbindungen zusammengefügt werden, sind oftmals weder besonders stabil noch ausreichend abgedichtet bzw. abgeschirmt.

Gewünscht ist also ein Gehäuse, das aus einigen wenigen Blechzuschnitten hergestellt ist, das möglichst schnell und problemlos montiert werden kann, das auch ohne Einsatz zusätzlicher Verbindungsmittel eine hohe mechanische Stabilität und eine sehr gute Dichtigkeit sowohl gegen Staub als auch gegen elektromagnetische Strahlung aufweist, und bei dem zumindest die Frontseite ohne Probleme nach Kundenwunsch ausgeführt werden kann.

Gelöst wird die Aufgabe durch ein Gehäuse mit den im ersten Patentanspruch angegebenen Merkmalen.

Das erfindungsgemäße Gehäuse ist zusammengesetzt aus wenigstens vier Teilen aus gebogenem Blech, nämlich einem Basisteil, einem ersten Seitenteil, einem zweiten Seitenteil und einem Deckel.

Das Basisteil ist U-förmig gebogen und umfasst eine rechteckige Bodenplatte sowie zwei nach oben abgekantete Seitenwände. Die beiden seitlich ansetzbaren Seitenteile bilden die Frontplatte oder die Rückwand des Gehäuses. Ein zwischen die Seitenteile einsetzbarer Deckel schließt das Gehäuse.

Wesentlich ist die Anordnung und die Ausbildung der Verbindungskanten. Darunter werden im Rahmen der Erfindung diejenigen Kanten der Gehäuseteile verstanden, welche notwendig sind, um die einzelnen Gehäuseteile ohne Werkzeug formschlüssig zusammenzufügen.

Erfindungsgemäß haben das U-förmige Basisteil und das erste Seitenteil jeweils zwei Verbindungskanten. Das zweite Seitenteil und der Deckel haben nur eine Verbindungskante. Alle Verbindungskanten verlaufen parallel zueinander.

An den Verbindungskanten zweier benachbarter Blechteile sind alternierend Verbindungslaschen und korrespondierende Steckzungen angeordnet. Die Verbindungslaschen und Steckzungen sind Z-förmig nach innen abgesetzt. Die Verbindungslaschen weisen beidseitig Freisparungen auf, in welche die korrespondierenden Steckzungen des benachbarten Blechteils partiell, das heißt ein Stück weit, von der Seite her eingreifen. Dadurch wird eine scharnierartige Verbindung zwischen benachbarten Blechteilen möglich, die eine Verschwenkung des einen Teils gegenüber dem anderen Teil um die gemeinsame Stoßkante erlaubt. Diese gelenkige Verbindung geht in eine formschlüssige Verbindung in montiertem Zustand über, dass heißt, die mittels Verbindungslaschen und Steckzungen verbundenen Gehäuseteile sind bei vollständig zusammengesetztem geschlossenen Gehäuse unverrückbar miteinander verbunden.

Zur Montage des erfindungsgemäßen Gehäuses werden zunächst die beiden Seitenteile mit ihren jeweiligen Verbindungskanten an die Verbindungskanten des Basisteils angesetzt, indem die Steckzungen an den Verbindungskanten der Seitenteile in die Freisparungen der Verbindungslaschen an den Verbindungskanten des Basisteils eingesteckt werden. Hierdurch ergibt sich eine zunächst scharnierartige Verbindung. Durch anschließendes Verschwenken der Seitenteile gehen die Verbindungslaschen und korrespondierenden Steckzungen eine formschlüssige Verbindung ein. Die beiden angesetzten Seitenteile bilden nun Frontseite und Rückseite des Gehäuses, die Seitenwände werden durch das U-förmige Basisteil gebildet.

Zuletzt wird der Deckel eingesetzt. Dazu werden die an der Verbindungskante des Deckels angeordneten Steckzungen in die Freisparungen der Verbindungslaschen an der oberen Verbindungskante des ersten Seitenteils eingesteckt, und zwar vorzugsweise hochkant. Durch anschließendes Verschwenken des Deckels in Richtung Bodenplatte - anders ausgedrückt: Zuklappen - entsteht eine formschlüssige Verbindung zwischen Deckel und Seitenteil entlang oder aneinander liegenden Kanten von Deckel und erstem Seitenteil.

Ist der Deckel ganz geschlossen, übergreift dessen rechtwinklig nach unten abgekanteter Rand das zweite Seitenteil. Da die dem Rand gegenüberliegende Verbindungskante des Deckels mit der Verbindungkante des angrenzenden ersten Seitenteils formschlüssig verbunden ist, zieht der Deckel beim Schließen die obere Verbindungskante des ersten Seitenteils gegen die vertikalen Kanten der Seitenwände des Basisteils.

Mit dem Schließen des Deckels stabilisieren sich alle vier Gehäuseteile gegenseitig. Es bedarf keiner weiteren Befestigungsmittel, um ein stabiles geschlossenes Gehäuse zu erhalten. Lediglich zur Sicherung gegenüber unbeabsichtigtem Öffnen kann im Bedarfsfall der Deckel zusätzlich mit einer oder zwei kleinen Schrauben mit dem zweiten Seitenteil verbunden werden.

Die Verbindungslaschen und Steckzungen sind ungefähr um die Blechdicke nach innen, dass heißt zum Innenraum des Gehäuses hin, abgesetzt. Dadurch ergibt sich die gewünschte Klemmwirkung nach dem Zusammenfügen der Blechteile. Bei den Verbindungslaschen schafft der Z-förmige Absatz im Zusammenwirken mit den seitlichen Freisparungen genau so viel Raum für den Eingriff der korrespondierenden Steckzungen, dass die Steckzungen ungehindert in die Freisparungen eingeführt und anschließend in diesen verschwenkt werden können, ohne sich zu verklemmen.

Um die Einführung der Steckzungen in die Freisparungen der Verbindungslaschen zu erleichtern, können die Steckzungen zu ihrem freien Ende hin schmaler ausgeführt sein, während sie im Bereich des Absatzes die volle Breite haben. Aufgrund ihrer konischen Kontur zentrieren sich die Steckzungen in den Freisparungen der Verbindungslaschen automatisch und gewährleisten so eine korrekte gegenseitige Ausrichtung der zu verbindenden Blechteile.

Obwohl es im Prinzip ausreicht, wenn pro Verbindungskante jeweils zwei Verbindungslaschen bzw. Steckzungen in ausreichendem seitlichen Abstand voneinander vorgesehen sind, ist es zweckmäßig, die Verbindungslaschen und Steckzungen über die ganze Länge einer Verbindungskante zu verteilen, vorzugsweise in einem modularen Raster. Zum einen lassen sich dadurch die Laschen und Zungen durch computergesteuerte Fertigungsmaschinen optimal herstellen, zum anderen ergibt sich eine homogene Verteilung der Verbindungskräfte entlang der Verbindunglinien.

Verbindungslaschen und Steckzungen müssen an den aneinanderstoßenden Verbindungskanten zweier benachbarter Blechteile alternierend so angeordnet sein, dass das eine Gehäuseteil, zum Beispiel ein Seitenteil, an das andere Gehäuseteil, zum Beispiel das Basisteil, zunächst mit einer Kante angesetzt und anschließend um diese Kante verschwenkt werden kann, um eine formschlüssige Verbindung zwischen den Steckzungen und den Verbindungslaschen herzustellen. In montiertem Zustand liegen dann die Steckzungen des angesetzten Blechteils, also zum Beispiel eines Seitenteils, in derselben Ebene wie die Verbindungslaschen des benachbarten Gehäuseteils, also zum Beispiel des Basisteils mit Bodenplatte. Aufgrund der alternierenden Anordnung wechseln sich Verbindungslaschen und Steckzungen entlang der gemeinsamen Verbindungskante ab. Im Bereich der Verbindungskante sind die Steckzungen etwas breiter als die Lücke zwischen den benachbarten Verbindungslaschen, so dass die Steckzungen rechts und links ein Stück weit in die Freisparungen der benachbarten Verbindungslaschen eingreifen.

Es gibt mehrere Möglichkeiten, die alternierenden Verbindungslaschen und Steckzungen so anzuordnen, dass sie bei montiertem Gehäuse parallel zu den Blechebenen beider, zu verbindender Blechteile liegen bzw. in derselben Ebene liegen. Eine erste Möglichkeit besteht darin, dass zum Beispiel die Verbindungslaschen des ersten Blechteils parallel zur Blechebene verlaufen und die Steckzungen des benachbarten Blechteils rechtwinklig gegenüber der Blechebene dieses zweiten Blechteils abgekantet sind. Eine zweite Möglichkeit besteht darin, eines der Blechteile, zum Beispiel ein Seitenteil, mit einem rechtwinklig nach innen abgekanteten Steg zu versehen und die Steckzungen bzw. Verbindungslaschen an die freie Kante dieses Steges zu verlegen. Da die Seitenwände sowie Front- und Rückseite eines rechteckigen Gehäuses naturgemäß vertikal, Boden und Deckel jedoch horizontal verlaufen, folgt daraus die Notwendigkeit, zumindest bei einem Teil der Verbindungskanten entweder die Verbindungslaschen oder die Steckzungen im rechten Winkel, bezogen auf die Blechebene der Hauptfläche des betreffenden Gehäuseteils, anzuordnen.

Bei einer bevorzugten Ausführung des erfindungsgemäßen Gehäuses weist das erste Seitenteil und das zweite Seitenteil rechtwinklig abgekantete Stege auf, deren freie Kanten die Verbindungskanten bilden, also Verbindungslaschen oder Steckzungen aufweisen. Dann lässt sich ein passendes Basisteil realisieren, bei dem an beiden Verbindungskanten die Verbindungslaschen parallel zur Ebene der Bodenplatte verlaufen. Um die Seitenteile anzusetzen, müssen diese um ungefähr 90 Grad nach außen gedreht werden, um nämlich die Steckzungen von unten in die Freisparungen der Verbindungslaschen des Basisteils einführen zu können. Steckzungen und Verbindungslaschen stehen dabei ungefähr rechtwinklig zueinander. Zur Herstellung der formschlüssigen Verbindung werden die Seitenteile anschließend in die Vertikale zurückgedreht, so dass Steckzungen und Verbindungslaschen ungefähr parallel verlaufen.

Bevorzugt ist das erste Seitenteil im Querschnitt U-förmig ausgebildet, wobei der ebene U-Rücken die Front- oder Rückseite des Gehäuses bildet und die freien Kanten der U-Schenkel als Verbindungskanten ausgebildet sind. Das zweite Seitenteil ist dann vorzugsweise L-förmig ausgebildet, wobei die freie Kante des kurzen L-Schenkels als Verbindungskante ausgebildet ist.

Weisen die Seitenteile rechtwinklig abgekantete Stege auf, ist es zweckmäßig, diese Stege um die unteren Ecken herum in die Vertikale zu führen. Der sich aus dem abgekanteten Steg ergebende Abstand zwischen der Hauptfläche des Seitenteils, das Front- oder Rückseite des Gehäuses bildet, und den vertikalen Kanten der angrenzenden Seitenwände wird durch die um die Ecke geführten Stege überbrückt. Bevorzugt ist also das zweite Seitenteil an drei Seiten rechtwinklig nach innen abgekantet.

Eines der Seitenteile, vorzugsweise das erste Seitenteil, kann an allen vier Seiten rechtwinklig nach innen abgekantete Stege aufweisen. Dieses Seitenteil ist dann also wannenartig oder in der Art einer Haube ausgebildet, welche die Seitenwände des Gehäuses verlängert. Die Länge der abgekanteten Stege ist dabei so zu bemessen, dass sie mindestens die Länge der Verbindungslaschen bzw. Steckzungen des benachbarte Blechteils aufnehmen können.

Auch die freien Kanten, die nicht als Verbindungskanten im Sinne dieser Erfindung ausgebildet sind, können optional mit weiteren, Z-förmig nach innen abgesetzten Steckzungen versehen werden, auch wenn diese zusätzlichen Steckzungen nicht dazu dienen, in Verbindungslaschen einzugreifen, um eine formschlüssige Verbindung herzustellen. Insbesondere ist es zweckmäßig, an der Oberkante des L-förmigen Seitenteils sowie an den freien Oberkanten der abgewinkelten Seitenwände des Basisteils solche zusätzlichen Steckzungen anzuordnen, welche parallel zur Blechebene gerichtet sind. Damit korrespondiert, dass der Rand des Deckels vorzugsweise an drei Seiten rechtwinklig nach unten abgekantet ist, so dass die nach oben ragenden Steckzungen an der Oberkante des zweiten Seitenteils und an den Oberkanten der Seitenwände des Basisteils von dem abgekanteten Rand des Deckels übergriffen werden, sobald der Deckel vollständig geschlossen ist. Die zusätzlichen Steckzungen überlappen sich beim Zusammenbau mit den Innenseiten des jeweils benachbarten Blechteils, so dass auch entlang dieser Kanten eine gewisse gegenseitige Klemmwirkung hergestellt wird. Auch der Deckel ist bevorzugt an zumindest drei Seiten optional mit zusätzlichen Steckzungen versehen, welche parallel zur Blechebene des angrenzenden Seitenteils bzw. der angrenzenden Seitenwände verlaufen.

Vorteilhaft tragen die Verbindungslaschen und/oder Steckzungen an ihren Außenseiten Klemmnasen oder vergleichbare Erhöhungen wie zum Beispiel Noppen oder Stege. Dadurch wird die Klemmwirkung zwischen Verbindungslasche bzw. Steckzunge und der Innenseite des benachbarten Blechteils erhöht. Die Klemmnasen sorgen darüber hinaus für eine zuverlässige elektrische Kontaktierung, die wichtig ist, um erhöhten Anforderungen an die elektromagnetische Verträglichkeit (EMV) zu erfüllen.

Gehäuse werden meistens lackiert, insbesondere pulverbeschichtet. Um die Blechteile, aus denen das erfindungsgemäße Gehäuse hergestellt ist, gut leitfähig miteinander zu verbinden, sollte darauf geachtet werden, dass zumindest die nach innen weisenden Seiten der Blechteile metallblank bleiben. Diese Forderung kann auf einfache Weise dadurch erfüllt werden, dass das Gehäuse zunächst montiert wird und erst nach dem Schließen des Deckels alle sichtbaren Außenseiten pulverbeschichtet werden.

Als Material für die Herstellung der Gehäuseteile kommt vor allem Stahlblech oder Aluminiumblech in Betracht. Die Gehäuseteile müssen nicht unbedingt aus demselben Material bestehen. Bevorzugt besteht zumindest eines der beiden Seitenteile, nämlich das die Front des Gehäuses bildende Seitenteil aus Aluminiumblech. Dies ermöglicht eine leichte Bearbeitung, die sowohl zeitgleich mit der Herstellung als auch nachträglich möglich ist, um die Frontplatte nach Kundenwunsch auszugestalten, insbesondere mit Löchern und Aussparungen zu versehen.

Im Folgenden wird nun ein Ausführungsbeispiel der Erfindung anhand der beigefügten Zeichnungen im Detail beschrieben. Es zeigen:
- Figur 1: ein geschlossenes Gehäuse, perspektivisch;
- Figur 2a: das Basisteil des Gehäuses von Figur 1;
- Figur 2b, 2c: die Verbindungskanten des Basisteils von Figur 2a;
- Figur 3a: eine Verbindungslasche, vergrößert;
- Figur 3b: eine Steckzunge, vergrößert;
- Figuren 4a - 4c: das erste Seitenteil des Gehäuses von Figur 1;
- Figur 5a, 5b: das zweite Seitenteil;
- Figur 6: den Deckel;
- Figur 7a - 7d: den Anbau der Seitenteile;
- Figur 8a - 8e: das Aufsetzen und Schließen des Deckels.

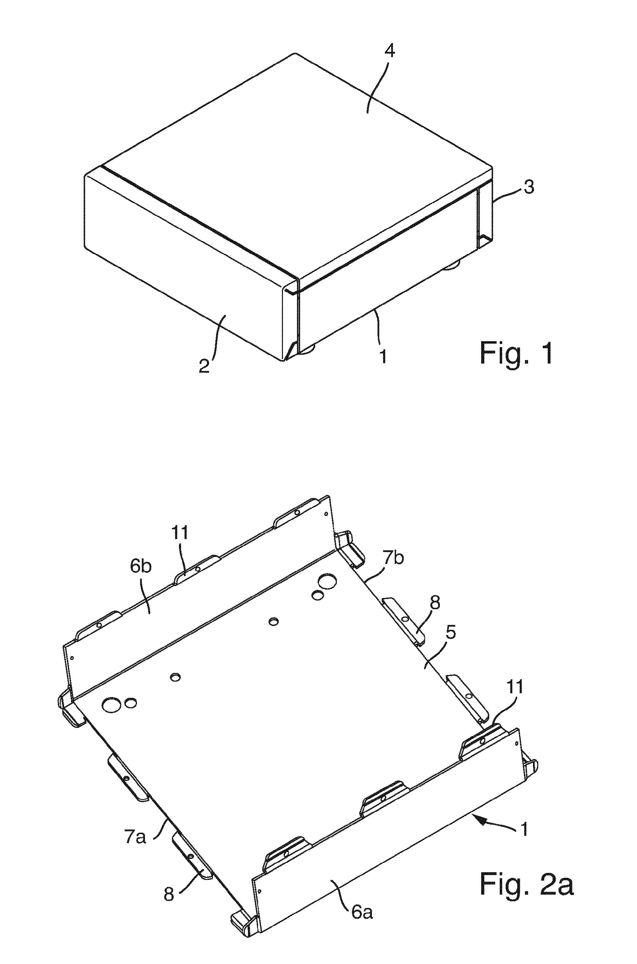

Das in Figur 1 abgebildete Gehäuse ist aus vier Teilen aus gebogenem Blech zusammengesetzt, nämlich einem Basisteil 1, einem ersten Seitenteil 2, einem zweiten Seitenteil 3 und einem Deckel 4.

Das Basisteil 1 und der Deckel 4 sind aus Stahlblech gefertigt, wohingegen das erste Seitenteil 2 und das zweite Seitenteil 3 aus Aluminiumblech besteht, das leichter nachträglich bearbeitet werden kann.

In Figur 2a ist das U-förmig gebogene Basisteil 1 alleine zu sehen. Es umfasst eine rechteckige Bodenplatte 5 und zwei rechtwinklig nach oben abgekantete Seitenwände 6a und 6b. Die beiden gegenüberliegenden Kanten der Bodenplatte 5, welche die Seitenwände 6a, 6b verbinden, sind als Verbindungskanten 7a, 7b ausgebildet. Entlang den Verbindungskanten 7a, 7b sind Verbindungslaschen 8 in regelmäßigen Abständen angeordnet.

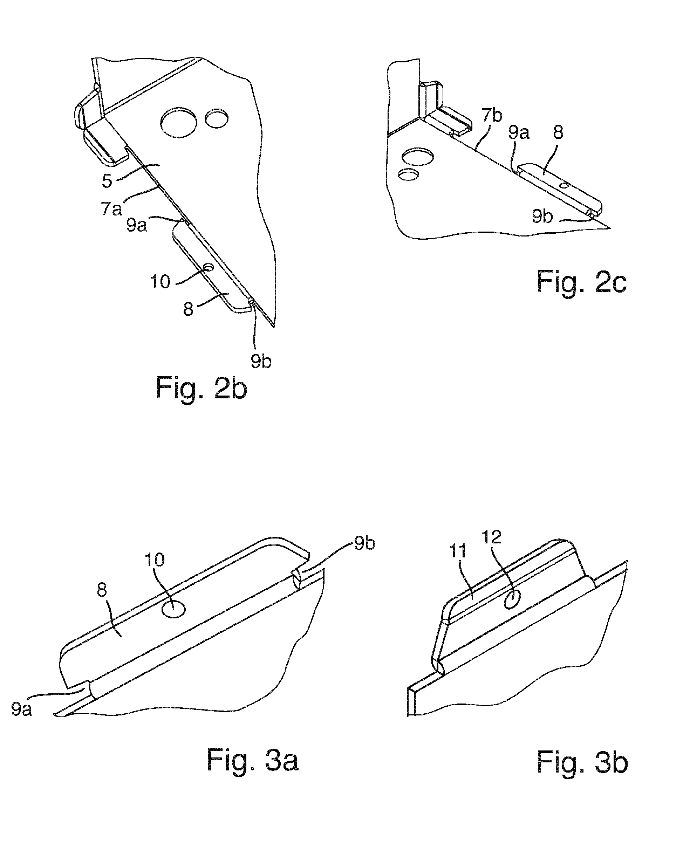

In den Figuren 2b, 2c sind die beiden Verbindungskanten 7a, 7b mit jeweils einer Verbindungslasche 8 in vergrößertem Maßstab zu sehen. Die Verbindungslaschen 8 sind gegenüber der Blechebene Z-förmig nach innen abgesetzt. Im Bereich des Absatzes sind rechts und links seitliche Freisparungen 9a, 9b vorgesehen. Diese Freisparungen 9a, 9b haben rechteckige Kontur. Die freien Ecken der Verbindungslaschen 8 sind abgerundet. In der Mitte tragen die Verbindungslaschen 8 eine Klemmnase 10, deren Erhebung nach unten, also zur Außenseite des Gehäuses hin weist.

Die abgekanteten Seitenwände 6a, 6b des Basisteils 1 weisen zusätzlich auch an ihren freien Kanten Steckzungen 11 auf. In Figur 2a sind beispielhaft jeweils drei Steckzungen 11 an den Oberkanten der Seitenwände 6a, 6b angeordnet. Entlang den Verbindungskanten 7a, 7b der Bodenplatte 5 sind jeweils zwei Verbindungslaschen 8 angeordnet sind. Größere Gehäuse wird man zweckmäßig mit einer größeren Anzahl von Verbindungslaschen 8 und Steckzungen 11 versehen.

In Figur 3a ist eine einzelne Verbindungslasche 8 vergrößert herausgezeichnet. In Figur 3b ist eine Steckzunge 11 in gleichem Maßstab zu sehen. Die Steckzungen 11 haben schräge Seitenkanten, verjüngen sich also mit zunehmendem Abstand von der Blechkante. Auch die Steckzungen 11 haben Klemmnasen 12, die nach außen weisen.

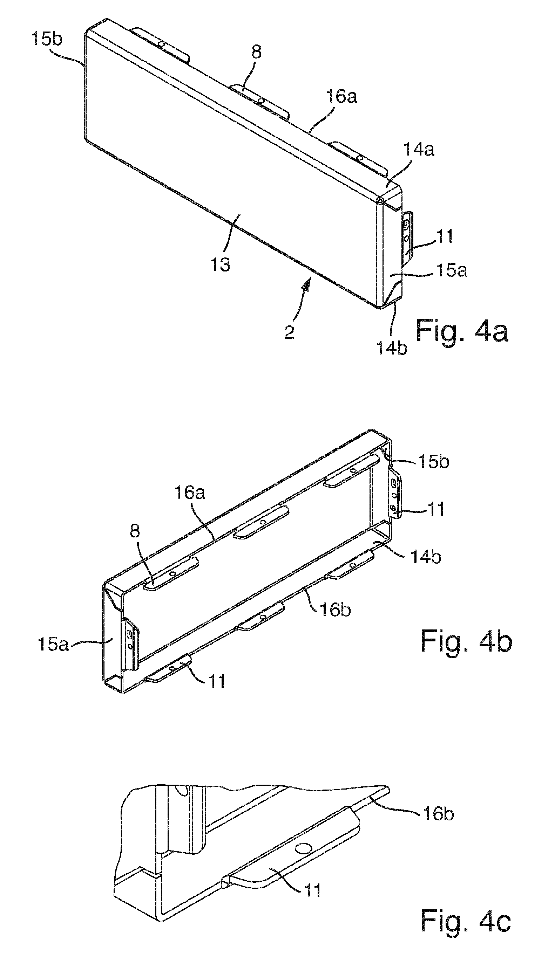

Das erste Seitenteil 2 (vgl. Figur 4a) weist an den langen Kanten Stege 14a, 14b auf, die rechtwinklig zur Innenseite des Gehäuses hin abgekantet sind.

Diese Stege 14a, 14b sind jeweils um die rechte und linke Ecke herumgeführt. An den beiden kurzen Seiten sind gleichfalls abgekantete Stege 15a, 15b gleicher Länge vorgesehen. Dieses Seitenteil 2 ist also wannenartig ausgebildet, wobei der Wannenboden die ebene Frontplatte 13 bildet. Die entlang der oberen und der unteren Kante vorgesehenen Stege 14a, 14b sind dabei als Verbindungskanten 16a, 16b ausgebildet. An der oberen Verbindungskante 16a sind Verbindungslaschen 8 angeordnet, wohingegen entlang der unteren Verbindungskante 16b drei Steckzungen 11 angeordnet sind (vgl. Figur 4b). In Figur 4c ist eine Steckzunge 11 an der unteren Verbindungskante 16b vergrößert dargestellt. Diese Verbindungslaschen 8 und Steckzungen 11 entsprechen den Figuren 3a und 3b. Verbindungslaschen 8 und Steckzungen 11 stehen in rechtem Winkel zur Frontplatte 13, verlaufen aber parallel zur Ebene der Stege 14a, 14b. An den seitlichen Stegen 15a, 15b sind zusätzliche Steckzungen 11 vorgesehen, die nicht mit Verbindungslaschen zusammenwirken.

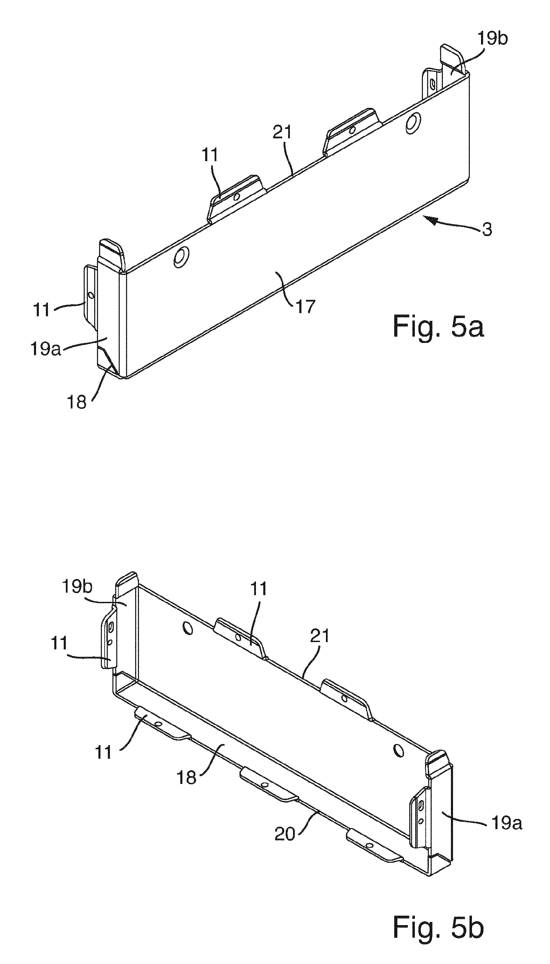

Das zweite Seitenteil 3 bildet die Rückwand 17 des Gehäuses (vgl. Figuren 1, 5a). Dieses Seitenteil 3 hat L-förmigen Querschnitt, wobei der lange L-Schenkel die Rückwand bildet und der kurze L-Schenkel durch einen rechtwinklig nach innen abgekanteten Steg 18 gebildet wird. Der Steg 18 ist um die unteren Ecken in die Vertikale geführt, wie insbesondere in Figur 5b zu sehen. An den kurzen Seiten sind zusätzliche Stege 19a, 19b rechtwinklig nach innen abgekantet. Diese bilden beim fertigen Gehäuse die Fortsetzung der Seitenwände 6a, 6b des Basisteils 1 (vgl. Figur 1). Auch an diesen seitlichen Stegen 19a, 19b sind zusätzliche Steckzungen 11 vorgesehen, die parallel zur Blechebene der Stege 19a, 19b verlaufen.

Bei dem zweiten Seitenteil 3 ist nur die freie Kante des Stegs 18 als Verbindungskante 20 ausgebildet. Entlang dieser Verbindungskante 20 sind Steckzungen 11 angeordnet, welche den anderen Steckzungen an Basisteil 1 und erstem Seitenteil 2 entsprechen (vgl. Figur 3b). An der oberen Kante 21, die der Verbindungskante 20 gegenüber liegt, sind weitere, gleich ausgebildete Steckzungen 11 angeordnet; diese verlaufen parallel zur Ebene der Rückwand 17 und wirken nicht mit Verbindungslaschen zusammen.

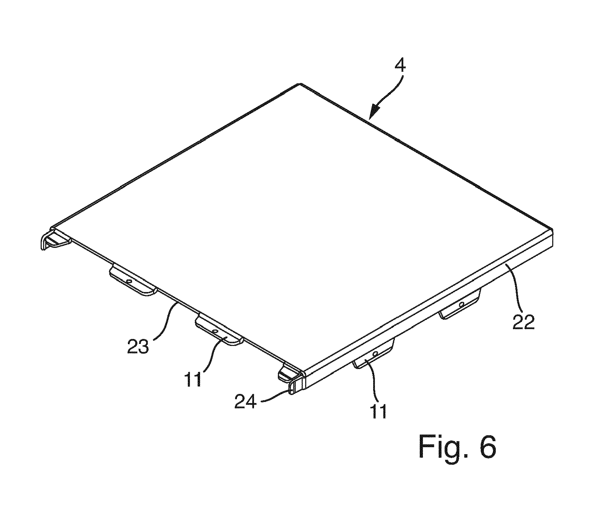

In Figur 6 ist der Deckel 4 als viertes und letztes Gehäuseteil allein zu sehen. Er bildet die ebene Oberseite des Gehäuses. Der Rand 22 des Deckels 4 ist an drei Seiten rechtwinklig nach innen, dass heißt in Figur 6 nach unten, abgekantet. An der vierten Seite ist eine Verbindungskante 23 ausgebildet, welche zwei Steckzungen 11 aufweist. Auch diese Steckzungen 11 entsprechen den Steckzungen an den anderen Gehäuseteilen. Weitere, gleich ausgebildete Steckzungen 11 befinden sich an den freien Kanten des nach unten gebogenen Rands 22, wobei diese weiteren Steckzungen 11 nicht mit Verbindungslaschen 8 zusammenwirken.

An der rechten und linken vorderen Ecke des Deckels 4 sind zusätzlich spezielle Eckzungen 24 vorgesehen. Ähnliche Eckzungen sind auch an den vier unteren Ecken des Basisteils 1 vorgesehen (vgl. Figur 2a).

Es wird nun der Zusammenbau des Gehäuses beschrieben.

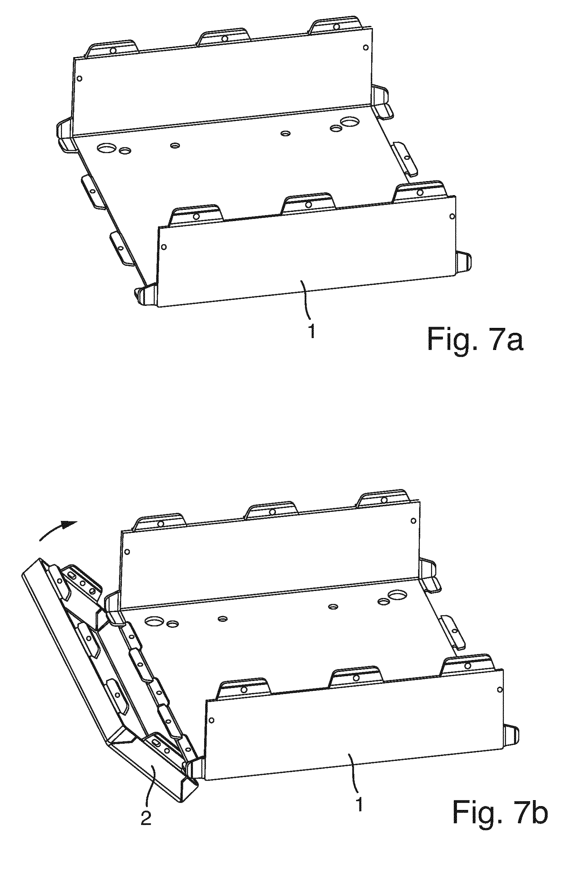

An das bereitgestellte Basisteil 1 (Figur 7a) wird zunächst das erste Seitenteil 2 angesetzt. Hierzu wird das Seitenteil 2 in gedrehter Lage mit seiner unteren Verbindungskante 16b (vgl. Figur 4b) an die angrenzende Verbindungskante 7a des Basisteils (vgl. Figur 2a) angesetzt. Dabei greifen die Steckzungen 11 an der Verbindungskante des Seitenteils 2 in die Freisparungen 9a, 9b der Verbindungslaschen 8 des Basisteils 1 ein. Wird nun das Seitenteil 2 gemäß Figur 7b in die Vertikale gedreht, entstehen zwischen den Verbindungslaschen 8 und den Steckzungen 11 zunächst scharnierartige, im folgenden formschlüssige Verbindungen.

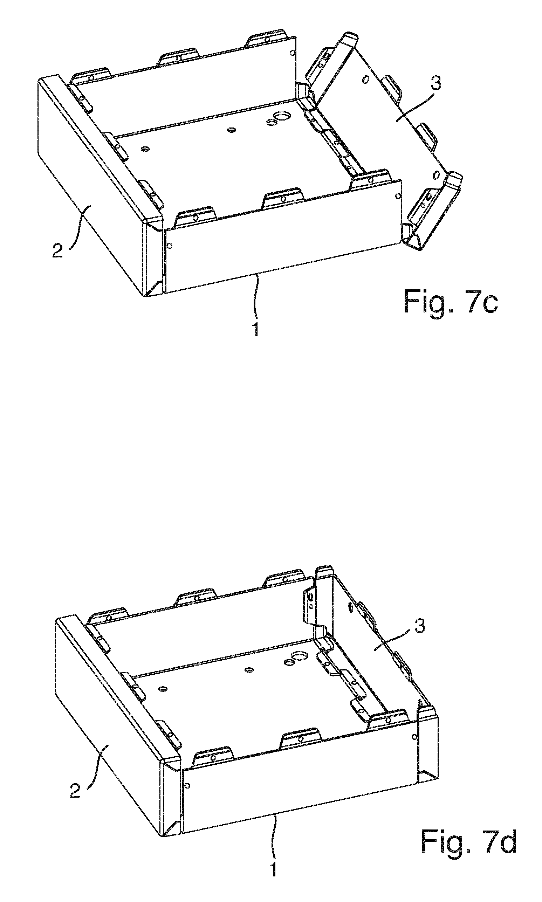

Im zweiten Schritt (Figur 7c) wird das zweite Seitenteil 3 an die gegenüberliegende zweite Verbindungskante 7b des Basisteils 1 (vgl. Figur 2a) angesetzt. Die alternierend angeordneten Verbindungslaschen 8 und Steckzungen 11 bilden auch hier eine scharnierartige formschlüssige Verbindung zwischen den beiden Gehäuseteilen.

In Figur 7d sind die beiden Seitenteile 2 und 3 nur mit ihren jeweiligen Unterkanten, die als Verbindungskanten 16b, 20 ausgebildet sind, mit dem Basisteil 1 formschlüssig verbunden. Die zusätzlichen Steckzungen 11 an den Stegen 15a, 15b bzw. 19a, 19b fixieren die Seitenteile 2, 3 durch bloße Klemmung an den Seitenwänden 6a, 6b des Basisteils 1. In diesem Zustand könnten also die Seitenteile 2, 3 noch relativ leicht wieder nach außen abgekippt werden; der bis dahin entstandene untere Teil des Gehäuses ist noch nicht in sich stabil.

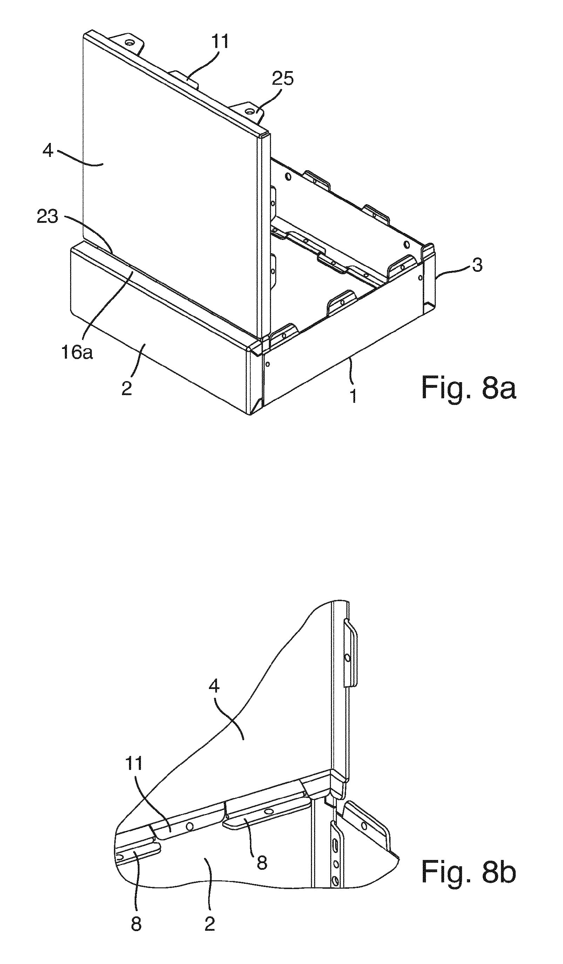

Zuletzt wird der Deckel 4 montiert. Wie in Figur 8a zu sehen, wird dazu der Deckel 4 ungefähr senkrecht gestellt und mit seiner Verbindungskante 23 an die obere Verbindungskante 16a des ersten Seitenteils 2 angesetzt. Wie in Figur 8b zu sehen, greifen dabei die Steckzungen 11 des Deckels 4 in die Freisparungen 9a, 9b (vgl. Figur 3a, Figur 4b) der korrespondierenden Verbindungslaschen 8 des Seitenteils 2 ein.

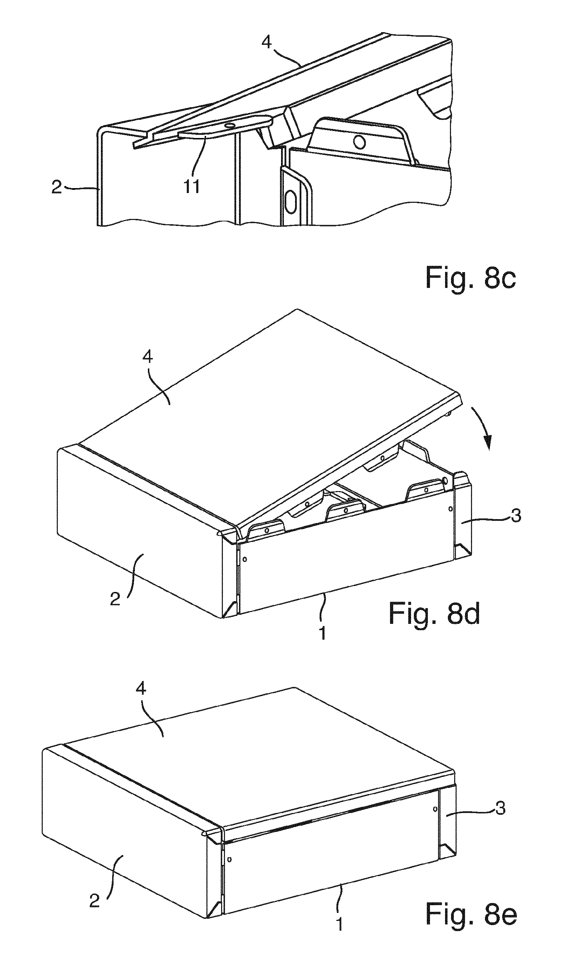

Wird nun der Deckel 4 verschwenkt, dass heißt zugeklappt, wirken die Verbindungslaschen 8 und die damit in Eingriff stehenden Steckzungen 11 als Scharnier (Figur 8c). Bei weiterem Schließen des Deckels (Figur 8d) geht die scharnierartige Verbindung in eine formschlüssige Verbindung über, dass heißt, der Deckel 4 kann sich nicht mehr von dem angrenzenden Seitenteil 2 lösen.

In Figur 8e ist der Deckel 4 ganz geschlossen. Sein abgekanteter Rand 22 übergreift die Steckzungen 11 an der Oberkante 21 des zweiten Seitenteils 3, das hier die Rückwand 17 des Gehäuses bildet. Damit wird das zweite Seitenteil 3 stabilisiert. Alle vier Gehäuseteile, also Basisteil 1, erstes Seitenteil 2, zweites Seitenteil 3 und Deckel 4 sind nun formschlüssig miteinander verbunden, ohne ein zusätzliches Befestigungselement. Die zusätzlichen Steckzungen 11 am Rand 22 des Deckels 4 und an den angrenzenden Oberkanten der Seitenwände 6a, 6b des Basisteils 1 sorgen für zusätzliche Stabilität.

Lediglich zur Sicherung gegen unbeabsichtigtes Abheben des Deckels 4 kann dieser bei Bedarf noch durch eine oder zwei kleine Schrauben mit dem zweiten Seitenteil 3 verbunden werden. Hierzu kann der Deckel 4 an seinem der Verbindungskante 23 gegenüberliegenden Rand eine oder zwei Gewindelaschen 25 aufweisen.

### Bezugszeichen

- 1: Basisteil
- 2: erstes Seitenteil
- 3: zweites Seitenteil
- 4: Deckel
- 5: Bodenplatte (1)
- 6a, 6b: Seitenwände (1)
- 7a, 7b: Verbindungskanten (1)
- 8: Verbindungslasche
- 9a, 9b: Freisparungen (8)
- 10: Klemmnase (8)
- 11: Steckzunge
- 12: Klemmnase (11)
- 13: Frontplatte (2)
- 14a, 14b: Stege (2)
- 15a, 15b: Stege (2)
- 16a, 16b: Verbindungskanten (2)
- 17: Rückwand (3)
- 18: Steg (3)
- 19a, 19b: Stege (3)
- 20: Verbindungskante (3)
- 21: Oberkante (3)
- 22: Rand (4)
- 23: Verbindungskante (4)
- 24: Eckzungen
- 25: Gewindelasche

## Patentansprüche

1. Gehäuse für elektrische Geräte, zusammengesetzt aus wenigstens vier Gehäuseteilen aus gebogenem Blech, umfassend
ein U-förmig gebogenes Basisteil (1) mit einer rechteckigen Bodenplatte (5) und zwei rechtwinklig nach oben abgekanteten Seitenwänden (6a, 6b), wobei die Bodenplatte (5) zwei gegenüberliegende Verbindungskanten (7a, 7b) hat, an denen Verbindungslaschen (8) angeordnet sind;
ein erstes, an die Bodenplatte (5) seitlich ansetzbares Seitenteil (2) mit einer unteren (16a) und einer oberen (16b) Verbindungskante, die beide parallel zu den Verbindungskanten (7a, 7b) der Bodenplatte (5) verlaufen, wobei an der unteren Verbindungskante (16a) Steckzungen (11) und an der oberen Verbindungskante Verbindungslaschen (8) angeordnet sind;
ein zweites, an die Bodenplatte (5) seitlich ansetzbares Seitenteil (3) mit einer Verbindungskante (20), die parallel zu den Verbindungskanten (7a, 7b) der Bodenplatte (5) verläuft und Steckzungen (11) aufweist;
einen zwischen die Seitenteile (2, 3) einsetzbaren Deckel (4) mit einer Verbindungskante (23), die parallel zu den anderen Verbindungskanten (7a, 7b, 16a, 16b) der anderen Gehäuseteile verläuft und Steckzungen (11) aufweist, und mit einem dieser Verbindungskante (23) gegenüberliegenden Rand (22), der rechtwinklig nach unten abgekantet ist, um die Oberkante des zweiten Seitenteils (3) zu übergreifen;
wobei die Verbindungslaschen (8) und die Steckzungen (11) Z-förmig nach innen abgesetzt und an den Verbindungskanten (7a, 7b, 16a, 16b, 20, 23) zweier benachbarter Gehäuseteile alternierend angeordnet sind;
und wobei die Verbindungslaschen (8) im Bereich des Absatzes seitliche Freisparungen (9a, 9b) aufweisen, in welche die korrespondierenden Steckzungen (11) des benachbarten Gehäuseteils partiell eingreifen, um dadurch eine scharnierartige formschlüssige Verbindung herzustellen.

2. Gehäuse nach Anspruch 1, **dadurch gekennzeichnet, dass** die Verbindungslaschen (8) und Steckzungen (11) ungefähr um die Blechdicke nach innen abgesetzt sind.

3. Gehäuse nach einem der vorhergehenden Ansprüche, **dadurch gekennzeichnet, dass** die Steckzungen (11) zu ihrem freien Ende hin schmaler werden.

4. Gehäuse nach einem der vorhergehenden Ansprüche, **dadurch gekennzeichnet, dass** die Verbindungslaschen (8) und Steckzungen (11) in einem modularen Raster entlang den Verbindungskanten angeordnet sind.

5. Gehäuse nach einem der vorhergehenden Ansprüche, **dadurch gekennzeichnet, dass** das erste Seitenteil (2) und/oder das zweite Seitenteil (3) rechtwinklig abgekantete Stege (14a, 14b; 18) aufweist, deren freie Kanten die Verbindungskanten (16a, 16b, 20) bilden.

6. Gehäuse nach einem der vorhergehenden Ansprüche, **dadurch gekennzeichnet, dass** das erste Seitenteil (2) im Querschnitt U-förmig ausgebildet ist, wobei der ebene U-Rücken die Front- oder Rückseite des Gehäuses bildet und die freien Kanten der U-Schenkel als Verbindungskanten (16a, 16b) ausgebildet sind.

7. Gehäuse nach vorhergehendem Ansprüche, **dadurch gekennzeichnet, dass** das erste Seitenteil (2) an vier Seiten rechtwinklig nach innen abgekantet ist.

8. Gehäuse nach einem der vorhergehenden Ansprüche, **dadurch gekennzeichnet, dass** das zweite Seitenteil (3) im Querschnitt L-förmig ausgebildet ist, wobei der lange L-Schenkel die Front- oder Rückseite des Gehäuses bildet und die freie Kante des kurzen L-Schenkels als Verbindungskante (20) ausgebildet ist.

9. Gehäuse nach einem der vorhergehenden Ansprüche, **dadurch gekennzeichnet, dass** das zweite Seitenteil (3) an drei Seiten rechtwinklig nach innen abgekantet ist.

10. Gehäuse nach einem der vorhergehenden Ansprüche, **dadurch gekennzeichnet, dass** an den freien Kanten der abgewinkelten Seitenwände (6a, 6b) des Basisteils (1) weitere Steckzungen (11) angeordnet sind, welche parallel zur Blechebene verlaufen.

11. Gehäuse nach einem der vorhergehenden Ansprüche, **dadurch gekennzeichnet, dass** der Rand (22) des Deckels (4) an drei Seiten rechtwinklig nach unten abgekantet ist.

12. Gehäuse nach einem der vorhergehenden Ansprüche, **dadurch gekennzeichnet, dass** die Verbindungslaschen (8) und/oder Steckzungen (11) an ihren Außenseiten Klemmnasen (10, 12) tragen.

13. Gehäuse nach einem der vorhergehenden Ansprüche, **dadurch gekennzeichnet, dass** die zur Innenseite des Gehäuses gerichteten Seiten der Gehäuseteile metallblank sind.

14. Gehäuse nach einem der vorhergehenden Ansprüche, **dadurch gekennzeichnet, dass** seine sichtbaren Außenseiten nach der Montage pulverbeschichtet sind.

15. Gehäuse nach einem der vorhergehenden Ansprüche, **dadurch gekennzeichnet, dass** zumindest eines der Seitenteile (2, 3) aus Aluminiumblech besteht.

## Claims

1. Housing for electrical devices, composed of at least four housing parts made of bent sheet metal, comprising
a base part (1) bent in a U-shape and having a rectangular bottom plate (5) and two side walls (6a, 6b) folded upward at a right angle, the bottom plate (5) having two opposing connecting edges (7a, 7b) on which connecting links (8) are arranged;
a first side part (2) configured for placement laterally against the bottom plate (5) and having lower (16a) and upper (16b) connecting edges, both of which run parallel to the connecting edges (7a, 7b) of the bottom plate (5), mounting tabs (11) being arranged on the lower connecting edge (16a) and connecting links (8) being arranged on the upper connecting edge;
a second side part (3) that can be placed laterally against the bottom plate (5) with a connecting edge (20) that runs parallel to the connecting edges (7a, 7b) of the bottom plate (5) and has mounting tabs (11);
a lid (4) that is insertable between the side parts (2, 3) and has a connecting edge (23) running parallel to the other connecting edges (7a, 7b, 16a, 16b) of the other housing parts and having mounting tabs (11), the lid having an edge (22) opposing this connecting edge (23) and being folded downward at a right angle to extend over the upper edge of the second side part (3);
wherein the connecting links (8) and the mounting tabs (11) are offset inwardly in a Z-shape and alternatingly arranged on the connecting edges (7a, 7b, 16a, 16b, 20, 23) of two adjacent housing parts;
and wherein the connecting links (8) have lateral cutouts (9a, 9b) in the region of the offset in which the corresponding mounting tabs (11) of the adjacent housing part engage partially to thereby establish a hinge-like positive connection.

2. Housing as set forth in claim 1, **characterized in that** the connecting links (8) and mounting tabs (11) are offset inwardly approximately by the sheet thickness.

3. Housing as set forth in any one of the preceding claims, **characterized in that** the mounting tabs (11) taper toward their free end.

4. Housing as set forth in any one of the preceding claims, **characterized in that** the connecting links (8) and mounting tabs (11) are arranged in a modular matrix along the connecting edges.

5. Housing as set forth in any one of the preceding claims, **characterized in that** the first side part (2) and/or the second side part (3) has web plates (14a, 14b; 18) folded over at a right angle, the connecting edges (16a, 16b, 20) formed by free edges of the web plates.

6. Housing as set forth in any one of the preceding claims, **characterized in that** the first side part (2) is U-shaped in cross section, wherein the flat U-back forms the front or rear side of the housing and the free edges of the U-arm are formed the connecting edges (16a, 16b).

7. Housing as set forth in any one of the preceding claims, **characterized in that** the first side part (2) is folded inwardly at a right angle on four sides.

8. Housing as set forth in any one of the preceding claims, **characterized in that** the second side part (3) has a L-shaped cross section, wherein the long L-arm forms the front or rear side of the housing and the free edge of the short L-arm forms as a connecting edge (20).

9. Housing as set forth in any one of the preceding claims, **characterized in that** the second side part (3) is folded inwardly at a right angle on three sides.

10. Housing as set forth in any one of the preceding claims, **characterized in that** additional mounting tabs (11) are arranged on the free edges of the folded side walls (6a, 6b) of the base part (1) that run parallel to the sheet plane.

11. Housing as set forth in any one of the preceding claims, **characterized in that** the edge (22) of the lid (4) is folded downwardly at a right angle on three sides.

12. Housing as set forth in any one of the preceding claims, **characterized in that** the connecting links (8) and/or mounting tabs (11) have clamping noses (10, 12) on their outer sides.

13. Housing as set forth in any one of the preceding claims, **characterized in that** the sides of the housing parts facing toward the inside of the housing are bare metal.

14. Housing as set forth in any one of the preceding claims, **characterized in that** its visible outer sides are powder-coated after assembly.

15. Housing as set forth in any one of the preceding claims, **characterized in that** at least one of the side parts (2, 3) is made of an aluminum sheet.

## Revendications

1. Boîtier pour appareils électriques, composé d'au moins quatre parties de boîtier en tôle pliée comprenant
une partie de base (1) pliée en forme de U avec une plaque de fond (5) rectangulaire et deux parois latérales (6a, 6b) repliées à angle droit vers le haut, la plaque de fond (5) ayant deux arêtes d'assemblage (7a, 7b) se faisant face sur lesquelles sont disposées des pattes d'assemblage (8) ;
une première partie latérale (2) applicable latéralement contre la plaque de fond (5) avec des arêtes d'assemblage inférieure (16a) et supérieure (16b) qui s'étendent toutes les deux parallèlement aux arêtes d'assemblage (7a, 7b) de la plaque de fond (5), sur l'arête d'assemblage inférieure (16a) étant disposées des languettes d'emboîtement (11) et sur l'arête d'assemblage supérieure des pattes d'assemblage (8) ;
une seconde partie latérale (3) applicable latéralement contre la plaque de fond (5) avec une arête d'assemblage (20) qui s' étend parallèlement aux arêtes d'assemblage (7a, 7b) de la plaque de fond (5) et présente des languettes d'emboîtement (11) ;
un couvercle (4) insérable entre les parties latérales (2, 3) avec une arête d'assemblage (23) qui s'étend parallèlement aux autres arêtes d'assemblage (7a, 7b, 16a, 16b) des autres parties de boîtier et présente des languettes d'emboîtement (11), et avec un bord (22) faisant face à cette arête d'assemblage (23), qui est replié à angle droit vers le bas de façon à recouvrir l'arête supérieure de la seconde partie latérale (3) ;
les pattes d'assemblage (8) et les languettes d'emboîtement (11) étant décalées en forme de Z vers l'intérieur et disposées en alternance sur les arêtes d'assemblage (7a, 7b, 16a, 16b, 20, 23) de deux parties de boîtier voisines ;
et les pattes d'assemblage (8) présentant au niveau du décrochement des évidements latéraux (9a, 9b) dans lesquels viennent s'engager partiellement les languettes d'emboîtement (11) correspondantes de la partie de boîtier voisine pour obtenir ainsi un assemblage par complémentarité de forme de type charnière.

2. Boîtier selon la revendication 1, **caractérisé en ce que** les pattes d'assemblage (8) et les languettes d'emboîtement (11) sont décalées vers l'intérieur environ de l'épaisseur de la tôle.

3. Boîtier selon l'une des revendications précédentes, **caractérisé en ce que** les languettes d'emboîtement (11) se rétrécissent en direction de leur extrémité libre.

4. Boîtier selon l'une des revendications précédentes, **caractérisé en ce que** les pattes d'assemblage (8) et les languettes d'emboîtement (11) sont disposées le long des arêtes d'assemblage selon un quadrillage modulaire.

5. Boîtier selon l'une des revendications précédentes, **caractérisé en ce que** la première partie latérale (2) et/ou la seconde partie latérale (3) présente des nervures (14a, 14b ; 18) repliées à angle droit, dont les bords libres forment les arêtes d'assemblage (16a, 16b, 20).

6. Boîtier selon l'une des revendications précédentes, **caractérisé en ce que** la première partie latérale (2) est de section en forme de U, le dos plan du U formant la face frontale ou arrière du boîtier et les bords libres des branches du U étant réalisés sous forme d'arêtes d'assemblage (16a, 16b).

7. Boîtier selon l'une des revendications précédentes, **caractérisé en ce que** la première partie latérale (2) est repliée à angle droit vers l'intérieur sur quatre côtés.

8. Boîtier selon l'une des revendications précédentes, **caractérisé en ce que** la seconde partie latérale (3) est de section en forme de L, la branche longue du L formant la face frontale ou arrière du boîtier et le bord libre de la branche courte du L étant réalisée sous forme d'arête d'assemblage (20).

9. Boîtier selon l'une des revendications précédentes, **caractérisé en ce que** la seconde partie latérale (3) est repliée à angle droit vers l'intérieur sur trois côtés.

10. Boîtier selon l'une des revendications précédentes, **caractérisé en ce que** d'autres languettes d'emboîtement (11) sont disposées aux bords libres des parois latérales (6a, 6b) repliées de la partie de base (1), lesquelles languettes s'étendent parallèlement au plan de la tôle.

11. Boîtier selon l'une des revendications précédentes, **caractérisé en ce que** le bord (22) du couvercle (4) est replié à angle droit vers le bas sur trois côtés.

12. Boîtier selon l'une des revendications précédentes, **caractérisé en ce que** les pattes d'assemblage (8) et/ou les languettes d'emboîtement (11) portent sur leurs côtés extérieurs des becs de serrage (10, 12).

13. Boîtier selon l'une des revendications précédentes, **caractérisé en ce que** les côtés des parties de boîtier tournés vers le côté intérieur du boîtier sont en métal brillant.

14. Boîtier selon l'une des revendications précédentes, **caractérisé en ce que** ses côtés extérieurs visibles après le montage sont munis d'un revêtement à poudre.

15. Boîtier selon l'une des revendications précédentes, **caractérisé en ce qu'**au moins une des parties latérales (2, 3) est en tôle d'aluminium.
